# EUROPEAN PATENT APPLICATION

(11) **EP 2 587 343 A1**
(43) Date of publication of application: **01.05.2013**
(21) Application number: 11192283.7
(22) Date of filing: 07.12.2011
(51) Int. Cl.: G06F 3/01, G06F 1/16

(54) **Method of generating 3d haptic feedback and an associated handheld electronic device**

(30) Priority: 24.10.2011 TW 100138439
(71) Applicant: Chief Land Electronic Co. Ltd., Wugu Dist., New Taipei City 248 (TW)
(72) Inventor: Ching, Chia-Nan, 32097 Zhongli City, Taoyuan County (TW); Chuang, Tsi-Yu, 52142 Changhua County (TW); Wang, Wen Chung, New Taipei City (TW)
(74) Representative: Karakatsanis, Georgios

(57) **Abstract**

The present invention is directed to a method of generating three dimensional (3D) haptic feedback and an associated handheld electronic device. A first, a second and a third directional actuator groups are disposed on an inner surface of a housing. The vibration inertial forces generated by the first, the second, and the third directional actuator groups are parallel with the first, the second and the third axial directions respectively. The first, the second, and the third directional actuator groups are individually or in combination driven, thereby generating haptic feedback.

## Description

### BACKGROUND OF THE INVENTION

### 1. FIELD OF THE INVENTION

The present invention generally relates to an actuator, and more particularly to a method of generating three-dimensional haptic feedback and an associated handheld electronic device.

### 2. DESCRIPTION OF RELATED ART

An actuator is an energy conversion device that, for example, converts electrical energy to mechanical energy, and the converted mechanical energy then further generates acoustic waves or haptic feedback. The actuator is commonly implemented by a smart material such as piezoelectric material, electroactive polymer (EAP), shape memory alloy (SMA), magnetostrictive material or electrostrictive material.

The actuator of a conventional haptic feedback device is usually disposed on a bottom surface of a screen. When the actuator is driven, it converts electrical energy to mechanical energy, and the converted mechanical energy then acts on the screen to result in vibration, which further generates haptic feedback. However, the conventional haptic feedback device generates only unidirectional vibration perpendicular to the screen. Therefore, application prospect of the haptic feedback device cannot be substantively expanded.

Therefore, a need has arisen to propose a novel method of generating three-dimensional haptic feedback and an associated handheld electronic device to improve the disadvantages mentioned above.

### SUMMARY OF THE INVENTION

In view of the drawbacks and limitations of the conventional haptic feedback device, the embodiment of the present invention provides a method of generating three-dimensional haptic feedback and an associated handheld electronic device for generating haptic feedback in three axial directions, therefore enhancing interaction between the electronic device and an user, in contrast to the unidirectional haptic feedback of the conventional electronic device.

According to one embodiment of the present invention, a three-dimensional haptic feedback handheld electronic device includes a housing, a first-directional actuator group, a second-directional actuator group and a third-directional actuator group. The first-directional actuator group is disposed on an inner surface of the housing, wherein the first-directional actuator group generates vibration inertial force that is parallel to a first axial direction. The second-directional actuator group is disposed on the inner surface of the housing, wherein the second-directional actuator group generates vibration inertial force that is parallel to a second axial direction and perpendicular to the first axial direction. The third-directional actuator group is disposed on the inner surface of the housing, wherein the third-directional actuator group generates vibration inertial force that is parallel to a third axial direction and perpendicular to a plane defined by the first axial direction and the second axial direction.

According to another embodiment of the present invention, at least a portion of the first-directional actuator group, at least a portion of the second-directional actuator group and at least a portion of the third-directional actuator group are individually or in combination driven to generate haptic feedback.

### BRIEF DESCRIPTION OF THE DRAWINGS

FIG. 1 shows an exploded view of components of a 3D haptic feedback handheld electronic device according to one embodiment of the present invention;
FIG. 2A shows a perspective view of an actuator of the first-directional actuator group, the second-directional actuator group and the third-directional actuator group of FIG. 1;
FIG. 2B shows a perspective view of another actuator of the first-directional actuator group, the second-directional actuator group and the third-directional actuator group of FIG. 1;
FIG. 3 shows a perspective top view of the first-directional actuator group, the second-directional actuator group and the third-directional actuator group disposed on the inner surface of the chassis frame and the chassis;
FIG. 4A to FIG. 4C show some exemplary driving signal waveforms;
FIG. 5 shows arrangement of the first-directional actuator group, the second-directional actuator group and the third-directional actuator group on the inner surface of the chassis frame and the chassis;
FIG. 6A to FIG. 6D show various types of haptic feedback generated by the first-directional actuator group;
FIG. 7A to FIG. 7D show various types of haptic feedback generated by the second-directional actuator group; FIG. 8A to FIG. 8F show various types of haptic feedback generated by the third-directional actuator group;
FIG. 9A to FIG. 9F show various types of haptic feedback generated by the first-directional actuator group and the second-directional actuator group;
FIG. 10A to FIG. 10D show various types of haptic feedback generated by the first-directional actuator group and the third-directional actuator group;
FIG. 11A to FIG. 11D show various types of haptic feedback generated by the second-directional actuator group and the third-directional actuator group; and
FIG. 12 shows a type of haptic feedback generated by the first-directional actuator group, the second-directional actuator group, and the third-directional actuator group.

### DETAILED DESCRIPTION OF THE INVENTION

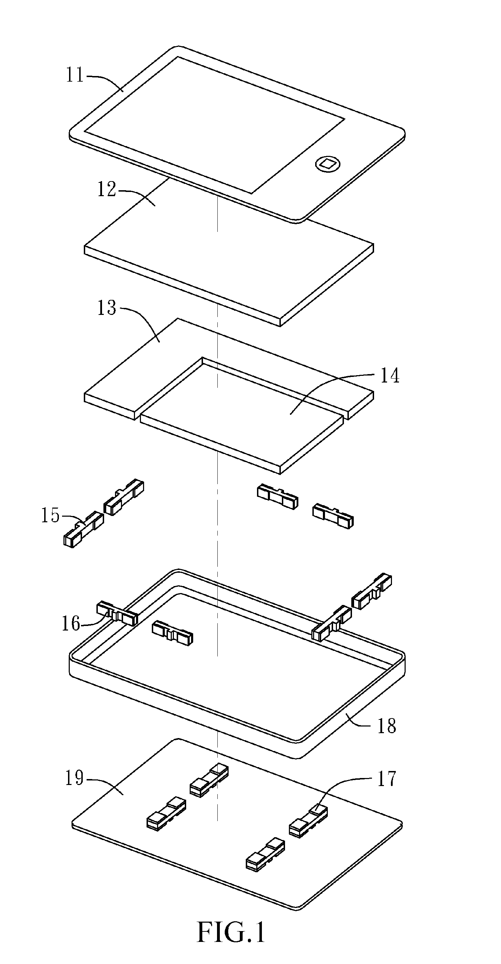

FIG. 1 shows an exploded view of components of a three-dimensional (3D) haptic feedback handheld electronic device according to one embodiment of the present invention. In the embodiment, the 3D haptic feedback handheld electronic device ("electronic device" hereinafter) includes, but not limited to, a touch panel 11, a display panel 12, a main board 13, a battery 14, a first-directional actuator group 15, a second-directional actuator group 16, a third-directional actuator group 17, a chassis frame 18 and a chassis 19. Specifically, the chassis frame 18 and the chassis 19 are perpendicular to each other, and are combined to act as a housing, which accompanies the touch panel 11 to define accommodation space. The first-directional actuator group 15, the second-directional actuator group 16 and the third-directional actuator group 17 are, individually or in combination, driven to generate vibration on the chassis frame 18 and the chassis 19, thereby resulting in haptic feedback for the electronic device.

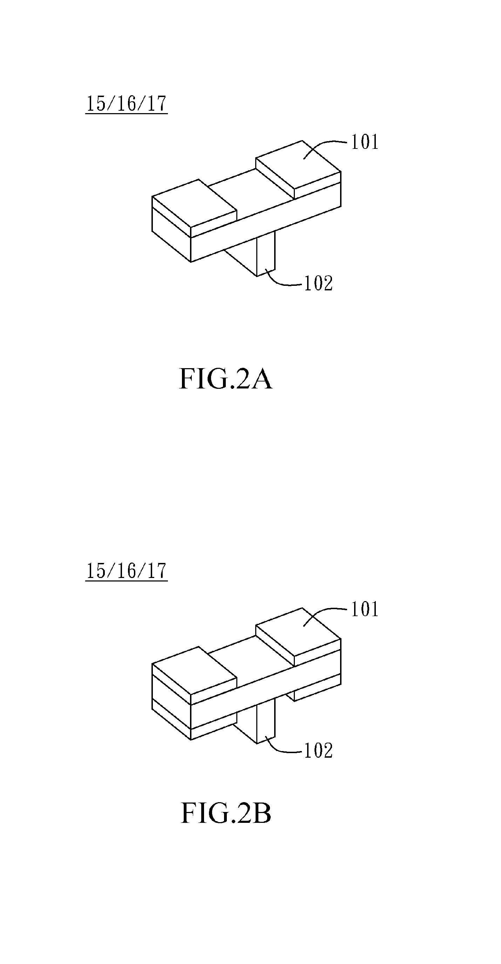

FIG. 2A shows a perspective view of an actuator of the first-directional actuator group 15, the second-directional actuator group 16 and the third-directional actuator group 17. In the embodiment, at least one inertial mass 101 may be further attached to at least one surface of the actuator 15/16/17 to enhance vibration inertial force. A support member 102 may be attached on another surface of the actuator 15/16/17. Specifically speaking, one end of the support member 12 is attached to, for example, center of the actuator 15/16/17, and the other end of the support member 12 is attached to the inner surface of the chassis frame 18 or the chassis 19, therefore providing a vibration space for the first-directional actuator group 15, the second-directional actuator group 16 and the third-directional actuator group 17. FIG. 2B shows a perspective view of another actuator of the first-directional actuator group 15, the second-directional actuator group 16, and the third-directional actuator group 17. In the embodiment, at least one inertial mass 101 is further attached to each of the two surfaces of the actuator 15/16/17. The actuator may be made of a material or device such as, but not limited to, piezoelectric material (e.g., lead zirconate titanate, PZT), electroactive polymer (EAP), shape memory alloy (SMA), magnetostrictive material, a voice coil motor or a linear resonant actuator (LRA). The actuator of the embodiment may include a unimorph actuator, a bimorph actuator or a multimorph actuator.

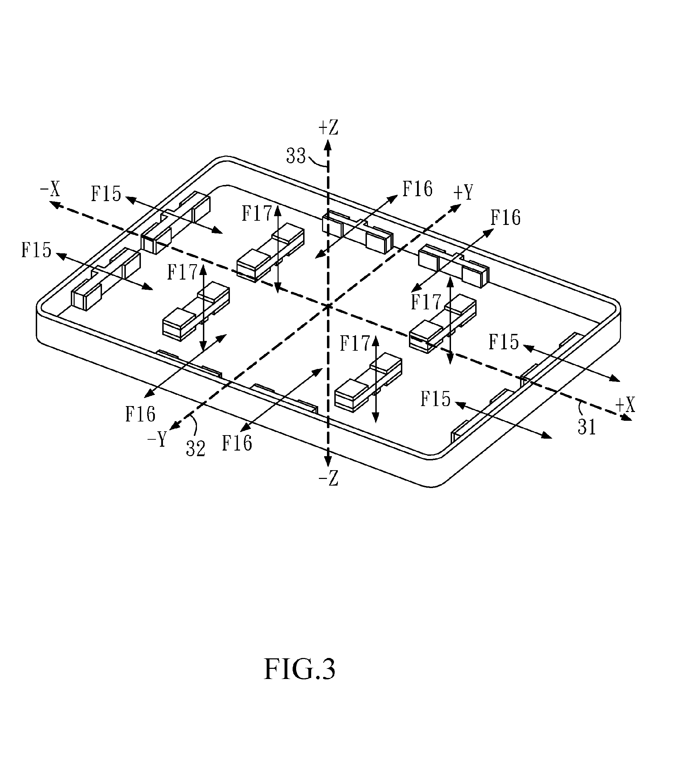

FIG. 3 shows a perspective top view of the first-directional actuator group 15, the second-directional actuator group 16 and the third-directional actuator group 17 disposed on the inner surface of the chassis frame 18 and the chassis 19. In the embodiment, each of the first-directional actuator group 15, the second-directional actuator group 16, and the third-directional actuator group 17 includes four actuators. The amount of the actuators in each axial direction is dependent on the required vibration strength, and the locations of the actuators in each axial direction are dependent on structural characteristics of the electronic device. As shown in FIG. 3, the first-directional actuator group 15 is disposed on the inner surface of the chassis frame 18, and generates vibration inertial force in a direction F15 parallel to a first axial direction (e.g., direction X or 31). The second-directional actuator group 16 is disposed on the inner surface of the chassis frame 18, and generates vibration inertial force in a direction F16 parallel to a second axial direction (e.g., direction Y or 32), which is perpendicular to the first axial direction 31. The third-directional actuator group 17 is disposed on the inner surface of the chassis 19, and generates vibration inertial force in a direction F17 parallel to a third axial direction (e.g., direction Z or 33), which is perpendicular to a plane defined by the first axial direction 31 and the second axial direction 32.

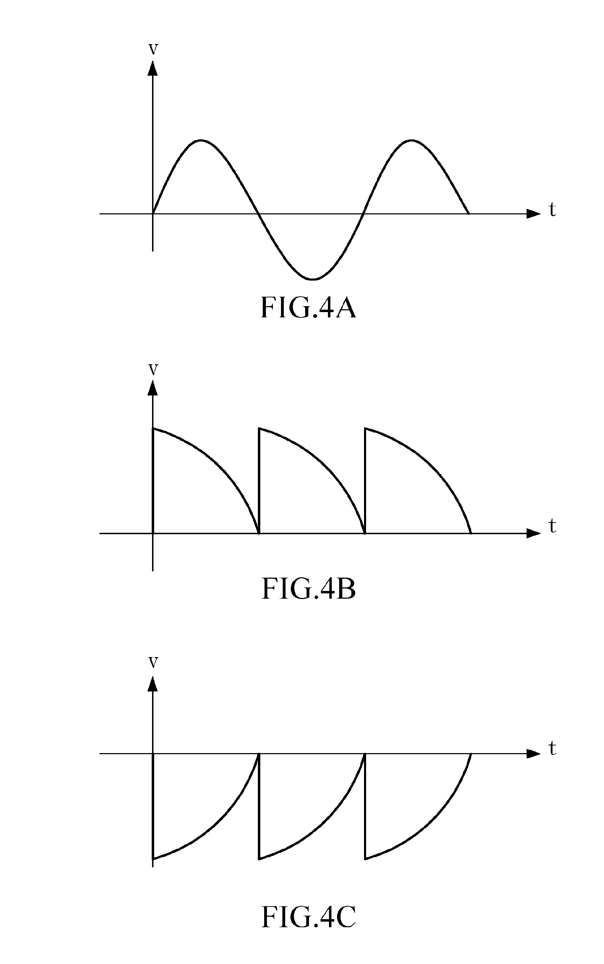

The actuator groups 15/16/17 are driven to generate vibration inertial forces associated with corresponding axial directions, respectively. FIG. 4A shows a driving signal waveform, which has positive and negative values with smooth rising/falling edge, for driving the actuator to result in bidirectional alternating vibration inertial force. FIG. 4B shows another driving signal waveform. Compared to FIG. 4A, the driving signal waveform of FIG. 4B has only positive values with sharp rising edge, for driving the actuator to result in unidirectional vibration inertial force, which continuously exerts force on the chassis frame 18 or the chassis 19 in one direction only. FIG. 4C shows a further driving signal waveform, which has only negative values with sharp falling edge, for driving the actuator to result in unidirectional vibration inertial force. Compared to FIG. 4B, the actuator of FIG. 4C continuously exerts force on the chassis frame 18 or the chassis 19 in a direction opposite to that in FIG. 4B.

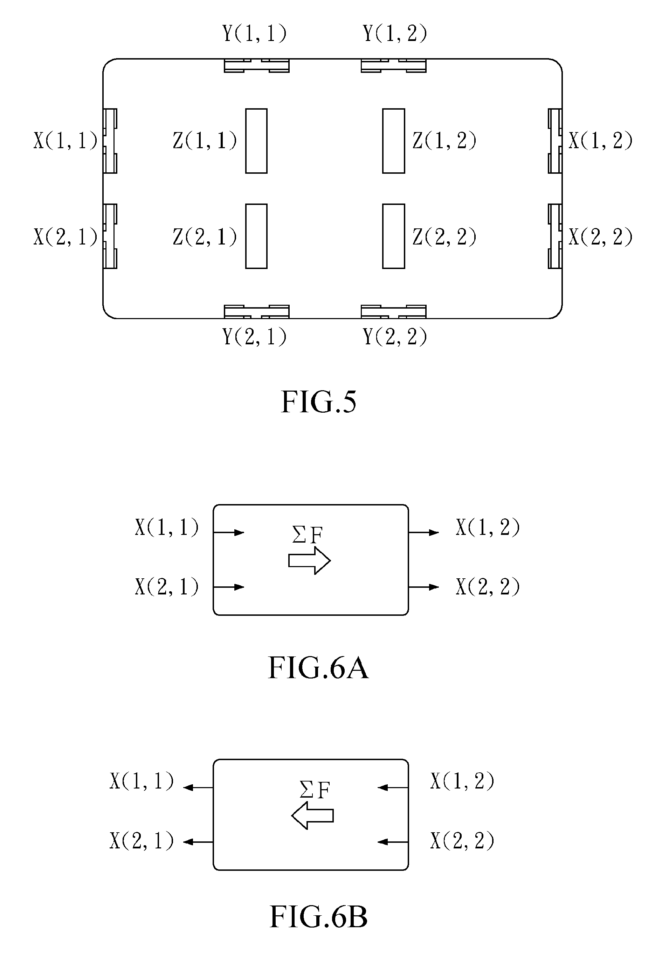

FIG. 5 shows arrangement of the first-directional actuator group 15, the second-directional actuator group 16, and the third-directional actuator group 17 on the inner surface of the chassis frame 18 and the chassis 19. Specifically, the actuators of the first-directional actuator group 15 are labeled as X(1,1), X(1,2), X(2,1), and X(2,2) respectively; the actuators of the second-directional actuator group 16 are labeled as Y(1,1), Y(1,2), Y(2,1), and Y(2,2) respectively; the actuators of the third-directional actuator group 17 are labeled as Z(1,1), Z(1,2), Z(2,1), and Z(2,2) respectively.

As described above, the first-directional actuator group 15, the second-directional actuator group 16 and the third-directional actuator group 17 may be, individually or in combination, driven to generate various types of haptic feedback, which will be detailed in the following. For better understanding, the first axial direction is exemplified by the direction X (31), the second axial direction is exemplified by the direction Y (32), and the third axial direction is exemplified by the direction Z (33).

FIG. 6A to FIG. 6D show various types of haptic feedback generated by the first-directional actuator group 15. As shown in FIG. 6A, the first-directional actuator group 15 is driven to generate a plurality of unidirectional vibration inertial forces with approximately the same amplitude and direction (e.g., positive direction X), as denoted by arrows, which collectively form a resultant force, as denoted by bold arrow (or ∑ F), directing to the positive direction X. The haptic feedback illustrated in FIG. 6B is similar to FIG. 6A except that the direction (e.g., negative direction X) is opposite to the direction (e.g., positive direction X) of FIG. 6A.

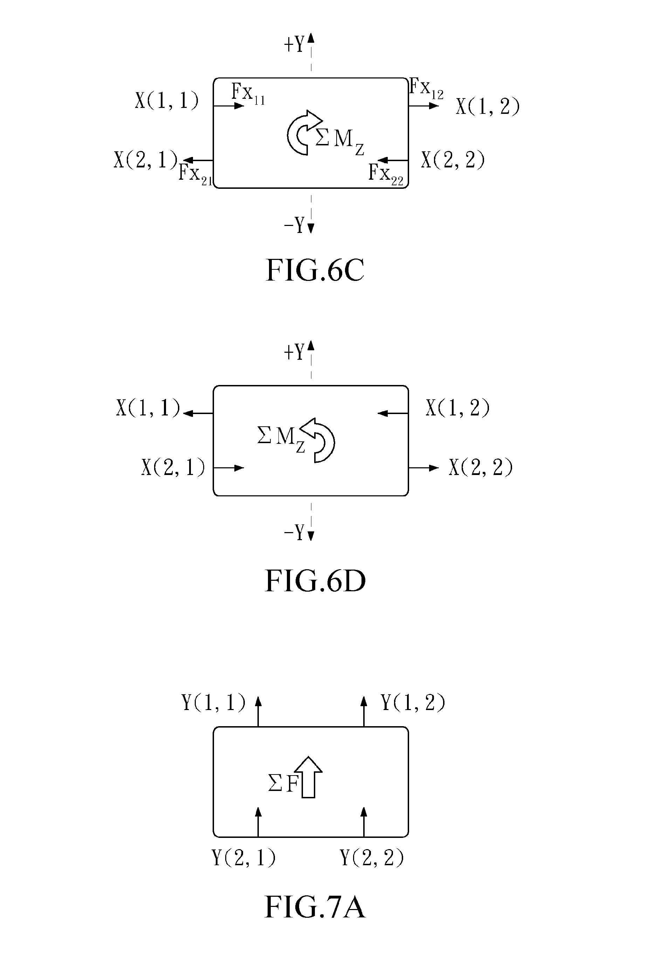

As shown in FIG. 6C, the actuators (e.g., X(1,1) and X(1,2)) of the first-directional actuator group 15 disposed along the positive direction Y are driven to generate at least one unidirectional first vibration inertial force (e.g., Fx₁₁ and Fx₁₂). Moreover, the actuators (e.g., X(2,1) and X(2,2)) of the first-directional actuator group 15 disposed along the negative direction Y are driven to generate at least one unidirectional second vibration inertial force (e.g., Fx₂₁ and Fx₂₂). The first vibration inertial force and the second vibration inertial force collectively form a resultant moment, as denoted by bold arrow (or ∑ Mz), rotating around direction Z, for example, clockwise. The haptic feedback illustrated in FIG. 6D is similar to FIG. 6C except that the first and the second vibration inertial forces and the direction of the resultant moment are opposite to those of FIG. 6C. In this specification, the term clockwise or counterclockwise is referred to a direction when facing the associated positive axis. For example, the resultant moment of FIG. 6C is clockwise when facing the positive axis Z.

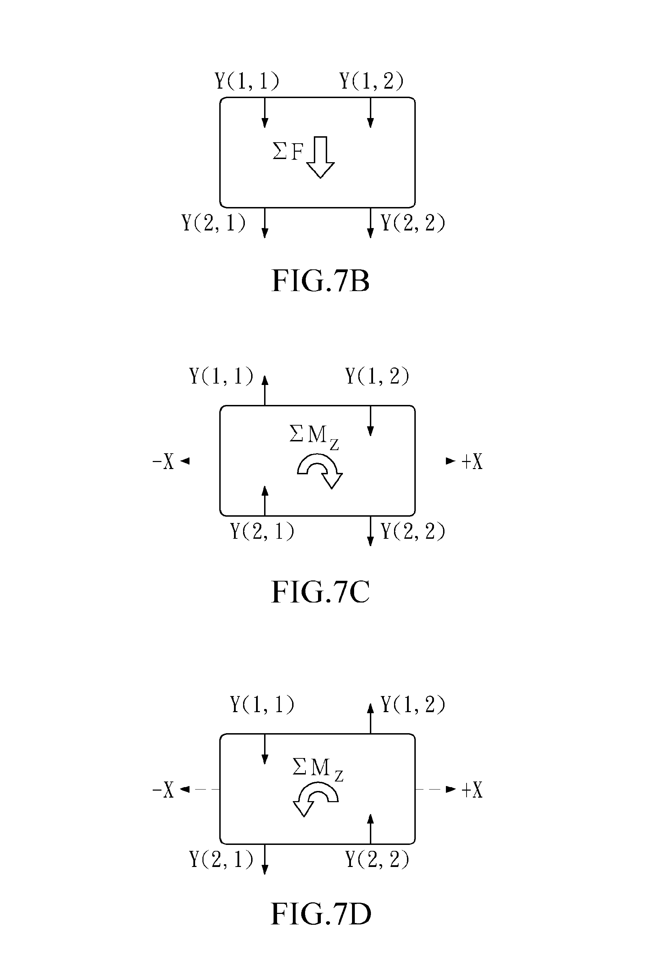

FIG. 7A to FIG. 7D show various types of haptic feedback generated by the second-directional actuator group 16, which are similar to those shown in FIG. 6A to FIG. 6D except that the axis X is replaced by the axis Y, and vice versa, and therefore the details are omitted for brevity.

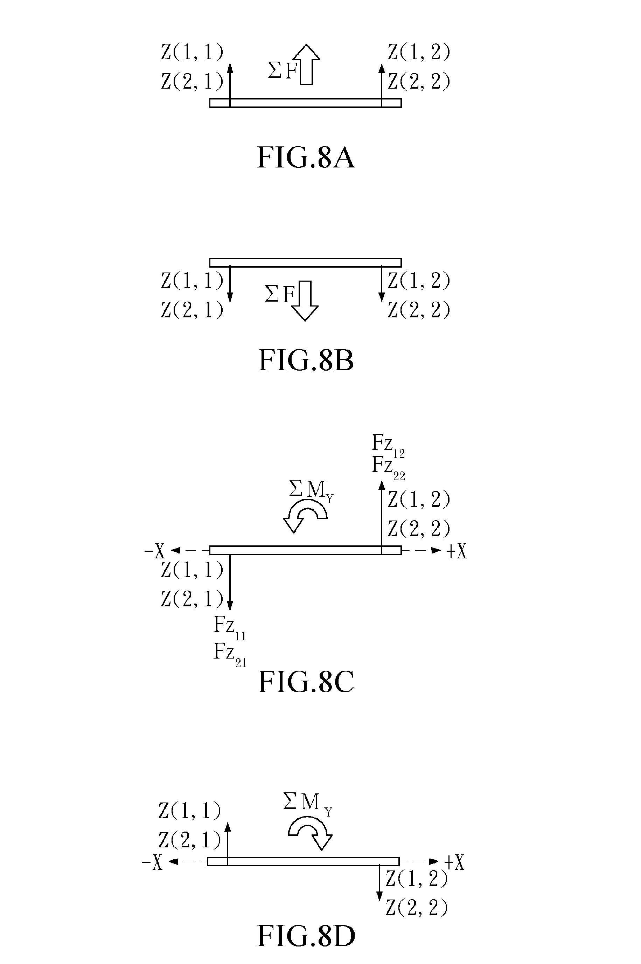

FIG. 8A to FIG. 8F show various types of haptic feedback generated by the third-directional actuator group 17. As shown in FIG. 8A, the third-directional actuator group 17 is driven to generate a plurality of unidirectional vibration inertial forces with approximately the same amplitude and direction (e.g., positive direction Z), as denoted by arrows, which collectively form a resultant force, as denoted by bold arrow (or ∑ F), directing to the positive direction Z. The haptic feedback illustrated in FIG. 8B is similar to FIG. 8A except that the direction (e.g., negative direction Z) is opposite to the direction (e.g., positive direction Z) of FIG. 8A.

As shown in FIG. 8C, the actuators (e.g., Z(1,2) and Z(2,2)) of the third-directional actuator group 17 disposed along the positive direction X are driven to generate at least one unidirectional first vibration inertial force (e.g., Fz₁₂ and Fz₂₂) directing to a first direction (e.g., positive direction Z). Moreover, the actuators (e.g., Z(1,1) and Z(2,1)) of the third-directional actuator group 17 disposed along the negative direction X are driven to generate at least one unidirectional second vibration inertial force (e.g., Fz₁₁ and Fz₂₁) directing to a second direction (e.g., negative direction Z) that is opposite to the first direction. The first vibration inertial force and the second vibration inertial force collectively form a resultant moment, as denoted by bold arrow (or ∑ M_{Y}), rotating around direction Y, for example, clockwise. The haptic feedback illustrated in FIG. 8D is similar to FIG. 8C except that the first and the second vibration inertial forces and the direction of the resultant moment are opposite to those of FIG. 8C.

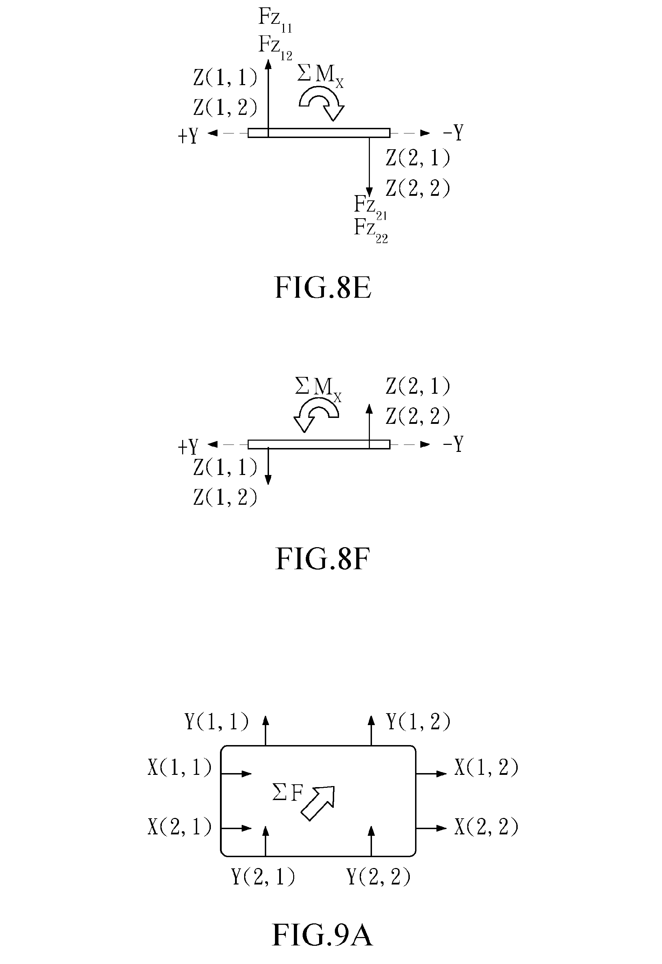

As shown in FIG. 8E, the actuators (e.g., Z(1,1) and Z(1,2)) of the third-directional actuator group 17 disposed along the positive direction Z are driven to generate at least one unidirectional first vibration inertial force (e.g., Fz₁₁ and Fz₁₂) directing to a first direction (e.g., positive direction Z). Moreover, the actuators (e.g., Z(2,1) and Z(2,2)) of the third-directional actuator group 17 disposed along the negative direction Y are driven to generate at least one unidirectional second vibration inertial force (e.g., Fz₂₁ and Fz₂₂) directing to a second direction (e.g., negative direction Z) that is opposite to the first direction. The first vibration inertial force and the second vibration inertial force collectively form a resultant moment, as denoted by bold arrow (or ∑ Mx), rotating around direction X, for example, counterclockwise. The haptic feedback illustrated in FIG. 8F is similar to FIG. 8E except that the first and the second vibration inertial forces and the direction of the resultant moment of are opposite to those of FIG. 8E.

The types of haptic feedback discussed above are generated by individually driving only the first-directional actuator group 15, the second-directional actuator group 16, or the third-directional actuator group 17. In the following, two or more of the first-directional actuator group 15, the second-directional actuator group 16, and the third-directional actuator group 17 are driven in combination to generate various types of haptic feedback.

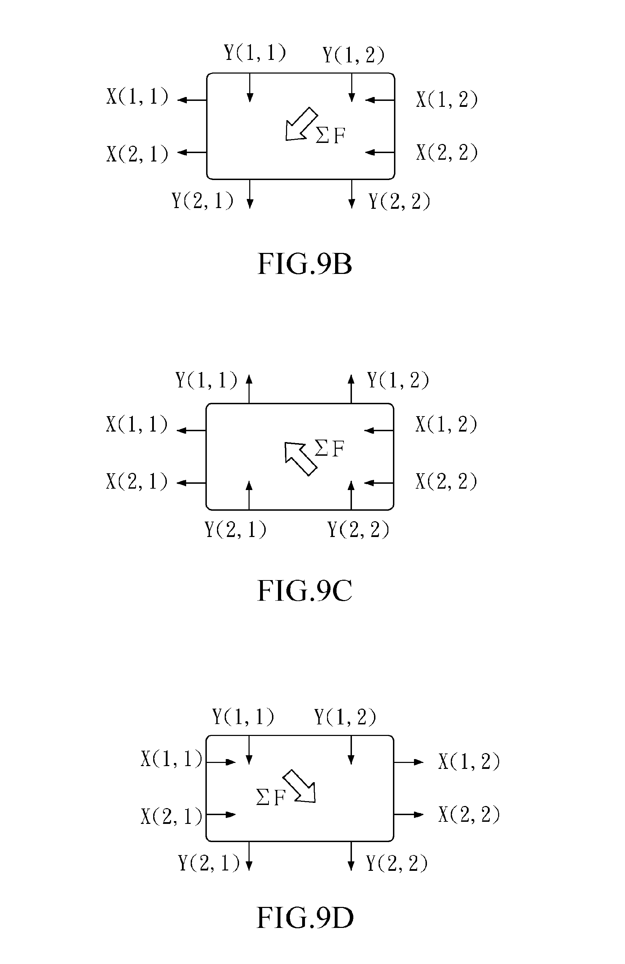

FIG. 9A to FIG. 9F show various types of haptic feedback generated by the first-directional actuator group 15 and the second-directional actuator group 16. As shown in FIG. 9A, the first-directional actuator group 15 is driven to generate a plurality of unidirectional vibration inertial forces with approximately the same amplitude and direction (e.g., positive direction X). Moreover, the second-directional actuator group 16 is driven to generate a plurality of unidirectional vibration inertial forces with approximately the same amplitude and direction (e.g., positive direction Y). The X-directional vibration inertial forces and the Y-directional vibration inertial forces collectively form a resultant force, as denoted by bold arrow (or ∑ F), directing to the direction between the positive direction X and the positive direction Y. The magnitude of the resultant force and the angle between the resultant force and the positive direction X are determined according to the sub-resultant force along the positive direction X and the sub-resultant force along the positive direction Y. The haptic feedback illustrated in FIG. 9B is similar to FIG. 9A except that the directions are opposite to the directions of FIG. 9A, respectively.

As shown in FIG. 9C, the first-directional actuator group 15 is driven to generate a plurality of unidirectional vibration inertial forces with approximately the same amplitude and direction (e.g., negative direction X). Moreover, the second-directional actuator group 16 is driven to generate a plurality of unidirectional vibration inertial forces with approximately the same amplitude and direction (e.g., positive direction Y). The X-directional vibration inertial forces and the Y-directional vibration inertial forces collectively form a resultant force, as denoted by bold arrow (or ∑ F), directing to the direction between the negative direction X and the positive direction Y. The magnitude of the resultant force and the angle between the resultant force and the negative direction X are determined according to the sub-resultant force along the negative direction X and the sub-resultant force along the positive direction Y. The haptic feedback illustrated in FIG. 9D is similar to FIG. 9C except that the directions are opposite to the directions of FIG. 9C, respectively.

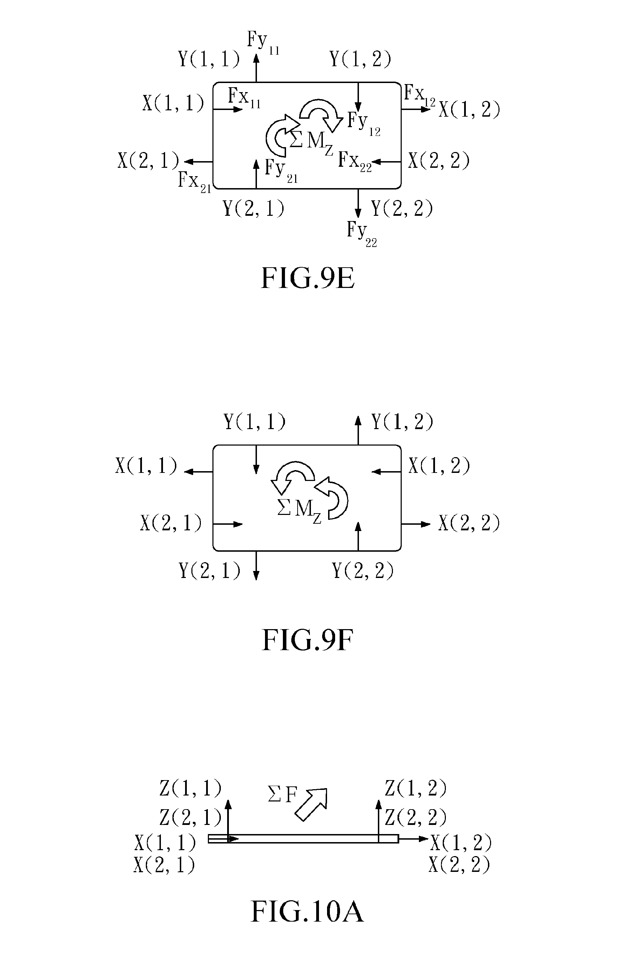

As shown in FIG. 9E, the actuators (e.g., X(1,1) and X(1,2)) of the first-directional actuator group 15 disposed along the positive direction Y are driven to generate at least one unidirectional first vibration inertial force (e.g., Fx₁₁ and Fx₁₂) directing to a first direction (e.g., positive direction X); the actuators (e.g., X(2,1) and X(2,2)) of the first-directional actuator group 15 disposed along the negative direction Y are driven to generate at least one unidirectional second vibration inertial force (e.g., Fx₂₁ and Fx₂₂) directing to a second direction (e.g., negative direction X) that is opposite to the first direction. The first vibration inertial force and the second vibration inertial force collectively form a sub-resultant moment, rotating around direction Z, for example, clockwise. Moreover, the actuators (e.g., Y(1,2) and Y(2,2)) of the second-directional actuator group 16 disposed along the positive direction X are driven to generate at least one unidirectional third vibration inertial force (e.g., Fy₁₂ and Fy₂₂) directing to a third direction (e.g., negative direction Y); the actuators (e.g., Y(1,1) and Y(2,1)) of the second-directional actuator group 16 disposed along the negative direction X are driven to generate at least one unidirectional fourth vibration inertial force (e.g., Fy₁₁ and Fy₂₁) directing to a fourth direction (e.g., positive direction Y) that is opposite to the third direction. The third vibration inertial force and the fourth vibration inertial force collectively form a sub-resultant moment, rotating around direction Z, for example, clockwise. The sub-resultant moments collectively form a resultant moment, rotating around direction Z, as denoted by bold arrow (or ∑ M_{z}), rotating around direction X, for example, counterclockwise. The haptic feedback illustrated in FIG. 9F is similar to FIG. 9E except that the directions of FIG. 9E are opposite to the directions of FIG. 9E, respectively.

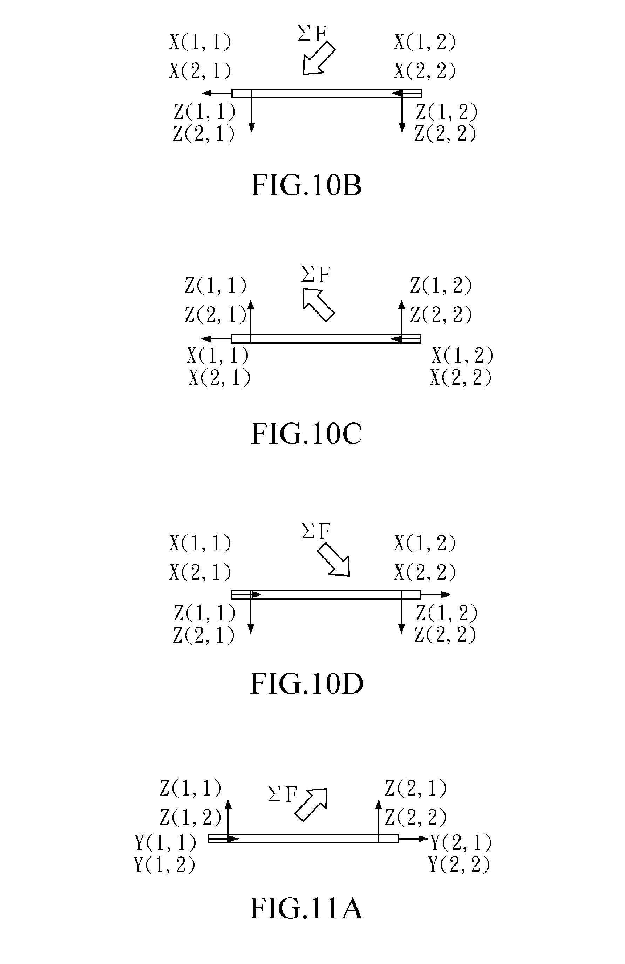

FIG. 10A to FIG. 10D show various types of haptic feedback generated by the first-directional actuator group 15 and the third-directional actuator group 17. As shown in FIG. 10A, the first-directional actuator group 15 is driven to generate a plurality of unidirectional vibration inertial forces with approximately the same amplitude and direction (e.g., positive direction X). Moreover, the third-directional actuator group 17 is driven to generate a plurality of unidirectional vibration inertial forces with approximately the same amplitude and direction (e.g., positive direction Z). The X-directional vibration inertial forces and the Z-directional vibration inertial forces collectively form a resultant force, as denoted by bold arrow (or ∑ F), directing to the direction between the positive direction X and the positive direction Z. The magnitude of the resultant force and the angle between the resultant force and the positive direction X are determined according to the sub-resultant force along the positive direction X and the sub-resultant force along the positive direction Z. The haptic feedback illustrated in FIG. 10B is similar to FIG. 10A except that the directions are opposite to the directions of FIG. 10A, respectively.

As shown in FIG. 10C, the first-directional actuator group 15 is driven to generate a plurality of unidirectional vibration inertial forces with approximately the same amplitude and direction (e.g., negative direction X). Moreover, the third-directional actuator group 17 is driven to generate a plurality of unidirectional vibration inertial forces with approximately the same amplitude and direction (e.g., positive direction Z). The X-directional vibration inertial forces and the Z-directional vibration inertial forces collectively form a resultant force, as denoted by bold arrow (or ∑ F), directing to the direction between the negative direction X and the positive direction Z. The magnitude of the resultant force and the angle between the resultant force and the negative direction X are determined according to the sub-resultant force along the negative direction X and the sub-resultant force along the positive direction Z. The haptic feedback illustrated in FIG. 10D is similar to FIG. 10C except that the directions are opposite to the directions of FIG. 10C, respectively.

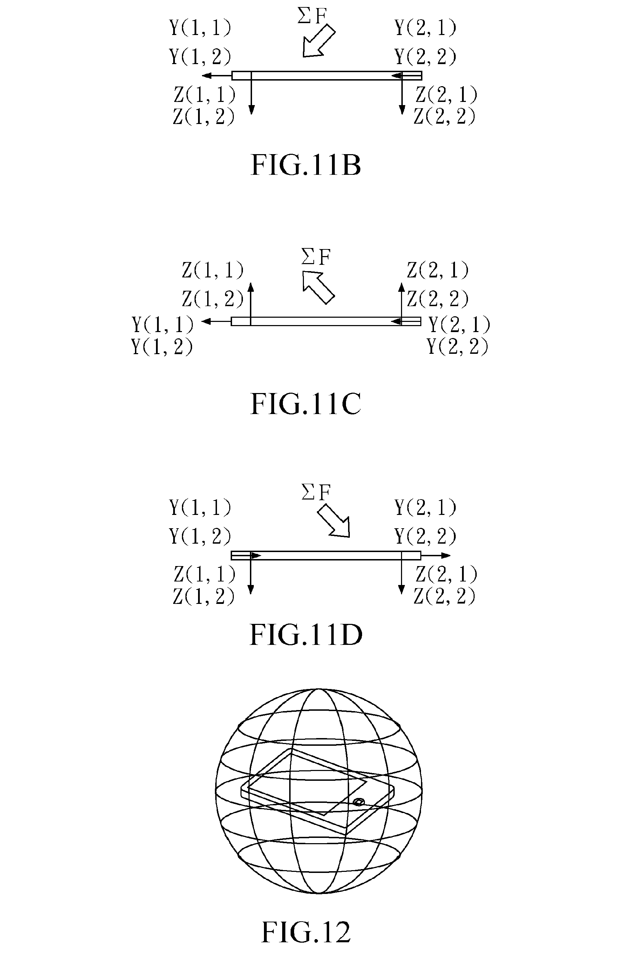

FIG. 11A to FIG. 11D show various types of haptic feedback generated by the second-directional actuator group 16 and the third-directional actuator group 17, which are similar to those shown in FIG. 10A to FIG. 10D except that the axis X is replaced by the axis Y, and vice versa, and therefore the details are omitted for brevity.

The types of haptic feedback discussed above are generated by individually driving only the first-directional actuator group 15, the second-directional actuator group 16, or the third-directional actuator group 17, or by driving two of the first-directional actuator group 15, the second-directional actuator group 16, and the third-directional actuator group 17. However, all of the first-directional actuator group 15, the second-directional actuator group 16, and the third-directional actuator group 17 may be driven in combination to generate various types of haptic feedback. Generally speaking, as shown in FIG. 12, a linear or rotational vibration haptic feedback along an arbitrary direction may be generated by driving the first-directional actuator group 15, the second-directional actuator group 16, and the third-directional actuator group 17 selectively.

According to the various types of haptic feedback discussed above, the embodiment may be adapted to generate haptic feedback in three axial directions, therefore enhancing interaction between the electronic device and a user, in contrast to the unidirectional haptic feedback of the conventional electronic device.

Although specific embodiments have been illustrated and described, it will be appreciated by those skilled in the art that various modifications may be made without departing from the scope of the present invention, which is intended to be limited solely by the appended claims.

## Claims

1. A three-dimensional haptic feedback handheld electronic device, comprising:
a housing;
a first-directional actuator group, disposed on an inner surface of the housing, wherein the first-directional actuator group generates vibration inertial force that is parallel to a first axial direction;
a second-directional actuator group, disposed on the inner surface of the housing, wherein the second-directional actuator group generates vibration inertial force that is parallel to a second axial direction and perpendicular to the first axial direction; and
a third-directional actuator group, disposed on the inner surface of the housing, wherein the third-directional actuator group generates vibration inertial force that is parallel to a third axial direction and perpendicular to a plane defined by the first axial direction and the second axial direction.

2. The electronic device of claim 1, wherein the housing comprises a chassis frame and a chassis, wherein a surface of the chassis frame is perpendicular to a surface of the chassis.

3. The electronic device of claim 1, wherein the first-directional actuator group, the second-directional actuator group, or the third-directional actuator group comprises at least one actuator.

4. The electronic device of claim 3, wherein the actuator comprises piezoelectric material, electroactive polymer (EAP), shape memory alloy (SMA), magnetostrictive material, a voice coil motor, or a linear resonant actuator (LRA).

5. The electronic device of claim 3, further comprising a support member having one end attached to the actuator, and another end attached to the inner surface of the housing.

6. The electronic device of claim 3, further comprising an inertial mass attached to at least one surface of the actuator.

7. A method of generating three-dimensional haptic feedback, comprising:
providing a first-directional actuator group, a second-directional actuator group, and a third-directional actuator group, wherein the first-directional actuator group generates vibration inertial force that is parallel to a first axial direction, the second-directional actuator group generates vibration inertial force that is parallel to a second axial direction and perpendicular to the first axial direction, and the third-directional actuator group generates vibration inertial force that is parallel to a third axial direction and perpendicular to a plane defined by the first axial direction and the second axial direction; and
individually or in combination driving at least a portion of the first-directional actuator group, at least a portion of the second-directional actuator group and at least a portion of the third-directional actuator group to generate haptic feedback.

8. The method of claim 7, wherein the first-directional actuator group, the second-directional actuator group, or the third-directional actuator group comprises at least one actuator.

9. The method of claim 8, wherein the actuator comprises piezoelectric material, electroactive polymer (EAP), shape memory alloy (SMA), magnetostrictive material, a voice coil motor or a linear resonant actuator (LRA).

10. The method of claim 7, wherein the driving step comprises:
driving the first-directional actuator group, the second-directional actuator group, or the third-directional actuator group to generate a plurality of unidirectional vibration inertial forces with substantially a same direction, wherein the plurality of unidirectional vibration inertial forces collectively form a resultant force.

11. The method of claim 7, wherein the driving step comprises:
driving a portion of the first-directional actuator group to generate at least one unidirectional first vibration inertial force directing to a first direction; and
driving another portion of the first-directional actuator group to generate at least one unidirectional second vibration inertial force directing to a second direction that is opposite to the first direction;
wherein the first vibration inertial force and the second vibration inertial force collectively form a resultant moment, rotating around the third axial direction.

12. The method of claim 7, wherein the driving step comprises:
driving a portion of the second-directional actuator group to generate at least one unidirectional first vibration inertial force directing to a first direction; and
driving another portion of the second-directional actuator group to generate at least one unidirectional second vibration inertial force directing to a second direction that is opposite to the first direction;
wherein the first vibration inertial force and the second vibration inertial force collectively form a resultant moment, rotating around the third axial direction.

13. The method of claim 7, wherein the driving step comprises:
driving a portion of the third-directional actuator group to generate at least one unidirectional first vibration inertial force directing to a first direction; and
driving another portion of the third-directional actuator group to generate at least one unidirectional second vibration inertial force directing to a second direction that is opposite to the first direction;
wherein the first vibration inertial force and the second vibration inertial force collectively form a resultant moment, rotating around the first or the second axial direction.

14. The method of claim 7, wherein the driving step comprises:
driving the first-directional actuator group to generate a plurality of unidirectional vibration inertial forces with substantially a same direction; and
driving the second-directional actuator group to generate a plurality of unidirectional vibration inertial forces with substantially a same direction;
wherein the plurality of unidirectional vibration inertial forces generated by the first-directional actuator group and the plurality of unidirectional vibration inertial forces generated by the second-directional actuator group collectively form a resultant force, pointing to a direction between the first axial direction and the second axial direction.

15. The method of claim 7, wherein the driving step comprises:
driving a portion of the first-directional actuator group to generate at least one unidirectional first vibration inertial force directing to a first direction;
driving another portion of the first-directional actuator group to generate at least one unidirectional second vibration inertial force directing to a second direction that is opposite to the first direction;
driving a portion of the second-directional actuator group to generate at least one unidirectional third vibration inertial force directing to a third direction; and
driving another portion of the second-directional actuator group to generate at least one unidirectional fourth vibration inertial force directing to a fourth direction that is opposite to the third direction;
wherein the first vibration inertial force and the second vibration inertial force collectively form a sub-resultant moment rotating around the third axial direction, and the third vibration inertial force and the fourth vibration inertial force collectively form a sub-resultant moment rotating around the third axial direction.

16. The method of claim 7, wherein the driving step comprises:
driving the first-directional actuator group to generate a plurality of unidirectional vibration inertial forces with substantially a same direction; and
driving the third-directional actuator group to generate a plurality of unidirectional vibration inertial forces with substantially a same direction;
wherein the plurality of unidirectional vibration inertial forces generated by the first-directional actuator group and the plurality of unidirectional vibration inertial forces generated by the third-directional actuator group collectively form a resultant force, pointing to a direction between the first axial direction and the third axial direction.

17. The method of claim 7, wherein the driving step comprises:
driving the second-directional actuator group to generate a plurality of unidirectional vibration inertial forces with substantially a same direction; and
driving the third-directional actuator group to generate a plurality of unidirectional vibration inertial forces with substantially a same direction;
wherein the plurality of unidirectional vibration inertial forces generated by the second-directional actuator group and the plurality of unidirectional vibration inertial forces generated by the third-directional actuator group collectively form a resultant force, pointing to a direction between the second axial direction and the third axial direction.

18. The method of claim 8, wherein the driving step further comprises:
providing a driving signal with a waveform having positive and negative values, for driving the actuator to result in bidirectional alternating vibration inertial force.

19. The method of claim 8, wherein the driving step further comprises:
providing a driving signal with a waveform having only positive values with a sharp rising edge, for driving the actuator to result in unidirectional vibration inertial force.
